# EUROPÄISCHE PATENTSCHRIFT

(11) **EP 0 756 326 B1**
(45) Veröffentlichungstag und Bekanntmachung des Hinweises auf die Patenterteilung: **19.12.2001**
(21) Anmeldenummer: 96111674.6
(22) Anmeldetag: 18.07.1996
(51) Int. Cl.: H01L 27/108, H01L 21/8242

(54) **Verfahren zur Herstellung einer Halbleiteranordnung mit Kondensator**
Method for producing a semiconductor device with a capacitor
Procédé de fabrication d'un dispositif semi-conducteur avec un condensateur

(30) Priorität: 24.07.1995 DE 19527023
(43) Veröffentlichungstag der Anmeldung: 29.01.1997
(73) Patentinhaber: Infineon Technologies AG, 81669 München (DE)
(72) Erfinder: Hönlein, Wolfgang, Dr., 82008 Unterhaching (DE); Widmann, Dietrich, Dr., 82008 Unterhaching (DE); Melzner, Hanno, 82008 Unterhaching (DE)
(74) Vertreter: Epping Hermann & Fischer

(56) Entgegenhaltungen:
- EP-A- 0 484 088
- EP-A- 0 513 988
- GB-A- 2 285 338
- US-A- 5 150 276
- IBM TECHNICAL DISCLOSURE BULLETIN, Bd. 33, Nr. 2, Juli 1990, NEW YORK US, Seiten 245-247, XP000123606 "Stacked Capacitor DRAM Cell with Vertical Fins (VF-STC)"
- PATENT ABSTRACTS OF JAPAN vol. 9, no. 118 (E-316), 23.Mai 1985 & JP-A-60 009154 (HITACHI SEISAKUSHO KK), 18.Januar 1985,
- H. SEIDEL ET AL: "Anisotropic Etching of Crystalline Silicon in Alkaline Solutions", J. ELECTROCHEM. SOC., , , Band 137, Nr. 11, Seiten 3626 - 3632

## Beschreibung

Die Erfindung betrifft ein Verfahren zur Herstellung eines Kondensators in einer Halbleiteranordnung, insbesondere in einer DRAM-Speicheranordnung, mit einer Elektrodenstruktur, die mehrere im Abstand voneinander angeordnete Elemente enthält, welche mit einer Verbindungsstruktur untereinander elektrisch verbunden sind, mit einem Kondensator-Dielektrikum und mit einer Gegenelektrode.

Eine Vielzahl integrierter Schaltungen benötigen Kondensatoren. Neben dem typischen Beispiel einer dynamischen Speicherzelle kommen Analog-Digital-Wandler bzw. Digital-Analog-Wandler und Filterschaltungen in Betracht. Insbesondere bei der Verkleinerung von Strukturen aufgrund der erhöhten Integrationsdichte oder weil Chipfläche eingespart werden muß, sind Maßnahmen erforderlich, um den an sich großen Platzbedarf eines Kondensators zu reduzieren. Als typisches Beispiel dient hier der dynamische Halbleiterspeicher, bei der die benötigte Fläche der üblicherweise verwendeten Eintransistor-Speicherzelle von Speichergeneration zu Speichergeneration bei zunehmender Speicherdichte reduziert wird. Gleichzeitig muß die Mindestkapazität des Speicherkondensators erhalten bleiben.

Bei dynamischen Halbleiterspeicheranordnungen umfaßt eine Eintransistor-Speicherzelle einen Auslesetransistor und einen Kondensator. Durch Ansteuerung des Auslesetransistors über eine Wortleitung kann die im Kondensator gespeicherte Information, d.h. die elektrische Ladung, über eine Bitleitung ausgelesen werden. Zur sicheren Speicherung der Ladung und gleichzeitigen Unterscheidbarkeit der ausgelesenen Information muß der Speicherkondensator eine Mindestkapazität aufweisen. Die untere Grenze für die Kapazität des Speicherkondensators wird derzeit bei 20 fF gesehen. Um diese Kondensatorkapazität zu erreichen, muß die Dicke des Dielektrikums möglichst klein und die Fläche des Kondensators möglichst groß gemacht werden.

Während bis zur 1 MBit-Speichergeneration sowohl der Auslesetransistor als auch der Kondensator als planare Bauelemente realisiert wurden, sind ab der 4 MBit-Speichergeneration Anordnungen bekannt, bei denen der Kondensator in einem Graben angeordnet ist (Trench Capacitor). Die Elektroden des Kondensators sind entlang der Oberfläche des Grabens angeordnet. Insgesamt ergibt sich eine wirksame Fläche des Kondensators, die gegenüber einer planaren Anordnung an der Oberfläche des Substrats vergrößert ist.

Eine weitere Möglichkeit zur Vergrößerung der Kapazität bei gleichbleibendem oder verringertem Platzbedarf des Kondensators besteht darin, diesen als Stapelkondensator (Stacked Capacitor) auszuführen. Dabei wird über den Wortleitungen eine Struktur aus Polysilizium, z. B. eine Kronenstruktur oder ein Zylinder gebildet, die mit dem Substrat kontaktiert wird. Die Polysiliziumstruktur bildet den Speicherknoten, der mit dem Kondensatordielektrikum und der Kondensatorplatte, der sogenannten Zellplatte versehen wird. Das Konzept hat den Vorteil, daß es mit einem Logikprozeß kompatibel ist.

Für den Kondensator wird der freie Raum oberhalb der Substratoberfläche genutzt. Dabei kann die gesamte Zellfläche von der Polysiliziumstruktur überdeckt sein, solange die Strukturen benachbarter Speicherzellen gegeneinander isoliert sind. Als Schlagworte sind in diesem Zusammenhang bekannt: fin stacked Capacitor und crown stacked Capacitor.

Aus der EP-A-0 415 530 ist eine Halbleiterspeicheranordnung mit einem Stapelkondensator als Speicherkondensator bekannt. Der Stapelkondensator umfaßt eine Polysiliziumstruktur mit mehreren im wesentlichen parallel übereinander angeordneten Polysiliziumschichten, die über mindestens eine seitliche Stütze miteinander verbunden sind. Die seitliche Stütze wird mit Hilfe einer Polysiliziumschicht erzeugt, die anschließend rückgeätzt wird, so daß ein im wesentlichen senkrecht angeordneter Steg verbleibt, der die übereinander angeordneten Polysiliziumschichten verbindet. Die Struktur wird durch eine alternierende Abscheidung von Polysiliziumschichten und dazu selektiv ätzbaren Siliziumoxidschichten auf der Oberfläche des Substrats, durch eine Strukturierung dieser Schichten, durch die Erzeugung der seitlichen Stützen an mindestens einer Flanke der Struktur und durch selektives Herausätzen der Siliziumoxidschichten gebildet. Die Polysiliziumstrukturen sind dabei arsendotiert. Anschließend wird durch thermische Oxidation Siliziumoxid als Kondensatordielektrikum gebildet, auf dem die Zellplatte aus dotiertem Polysilizium abgeschieden wird.

Aus der US-A-5,240,871 ist ein Kondensator mit übereinanderliegenden Elektrodenschichten bekannt, bei dem auf einer Polysiliziumschicht unterschiedlich schnell ätzende Isolationsschichten aufgetragen werden, die anschließend strukturiert und geätzt werden, so daß ein Stützgerüst entsteht. Danach wird dotiertes Polysilizium abgeschieden, anschließend eine Siliziumnitridschicht, worauf sich die Bildung der Zellplatte anschließt.

Eine Kondensatoranordnung mit vertikalen Speicherelementen ist in IBM-Technical Disclosure Bulletin, Bd. 33, Nr. 2, 1990, S. 245-247 beschrieben. Die Elektroden des Kondensators bestehen dort vollständig aus p-dotiertem Polysilizium. Zur Herstellung der Kondensatoranordnung werden Spacer verwendet, die eine im Querschnitt dreiarmige Ausgestaltung des Kondensators ermöglichen.

Ein Herstellverfahren für einen fin stacked capacitor ist in GB-A-2 285 338 beschrieben. Auf einer isolierenden Schicht wird eine Schichtenfolge von n-dotierten und undotierten Polysiliziumschichten aufgebracht, dann wird eine Öffnung in diese Schichtenfolge geätzt. In der Öffnung wird eine undotierte Polysiliziumschicht aufgebracht. Das dotierte Polysilizium wird selektiv geätzt, anschließend wird das undotierte Polysilizium n-dotiert.

Der Erfindung liegt das Problem zugrunde, ein Herstellungsverfahren für einen Kondensator in einer Halbleiterspeicherung anzugeben, der bei reduziertem Prozeß- und Platzaufwand eine hohe Packungsdichte ermöglicht.

Diese Problem wird gelöst durch ein Verfahren zur Herstellung eines Kondensators mit den Merkmalen des Anspruchs 1.

Der mit dem Verfahren erzeugte Kondensator besitzt den Vorteil, daß die Dicke des Kondensators bei liegender Anordnung bzw. die Breite des Kondensators bei stehender Anordnung geringer ist als bei den bekannten Kondensatoren. Der Kondensator läßt sich insbesondere bei DRAM-Halbleiteranordnungen einsetzen, da er für die erforderliche minimale Zellkapazität von 20 fF eine geringe Dicke und eine geringe Fläche beansprucht. Es läßt sich abschätzen, daß sich mit einem derartigen Kondensator auch die Speicherkapazitäten zukünftiger DRAM-Generationen realisieren lassen, die hinsichtlich ihres Flächenbedarfs noch weiter verschärfte Anforderungen stellen. Dazu ist es lediglich erforderlich, bei einer reduzierten Fläche einer Lage die Anzahl der Lagen zu erhöhen. Weiterhin ist es möglich, die Dicke bzw. die Breite des Kondensators durch Reduktion der Schichtdicke und der Dielektrikumsdicke zu verringern. Der Kondensator hat weiterhin den Vorteil, daß seine Elektrodenstruktur bei p-Kanal-Transistoren mit Hilfe eines Kontaktlochs unmittelbar mit dem Drain des Transistors verbunden werden kann. Es sind aber auch andere Kontaktierungen der Elektrodenstruktur zu anderen Schaltungselementen möglich. Beispielsweise kann bei einem n-Kanal-Auswahltransistor eine Kontaktierung der Elektrodenstruktur mit dem Drain des Transistors über eine Metallzwischenschicht, beispielsweise aus Tantal, Titan, Titannitrid oder eine Silizidschicht oder eine Kontaktlochauffüllung, beispielsweise mit Wolfram erfolgen.

Das erfindungsgemäße Verfahren besitzt den wesentlichen Vorteil gegenüber bekannten Verfahren, daß weniger Prozeßschritte erforderlich sind, ohne daß Einbußen in anderer Hinsicht in Kauf genommen werden müssen.

Ausgestaltungen der Erfindung sind in Unteransprüchen gekennzeichnet.

Es ist vorgesehen, daß der Kondensator in einer Halbleiteranordnung eine Elektrodenstruktur hat, die mehrere im Abstand voneinander angeordnete Elemente enthält, welche mit einer Verbindungsstruktur untereinander elektrisch verbunden sind, wobei die Elemente der Elektrodenstruktur und die zugehörige Verbindungsstruktur vollständig aus p-dotiertem Material mit einer Dotierung > 10²⁰ cm⁻³ besteht. Dabei können die Elemente dieser Elektrodenstruktur flächig übereinander angeordnet sein. Die Verbindungsstruktur erstreckt sich an mindestens einem Rand in Richtung quer zur Fläche der Elemente. Andererseits können die Elemente der Elektrodenstruktur topfförmig ausgebildet und ineinander verschachtelt sein, wobei die Verbindungsstruktur innerhalb des topfförmigen Bereichs mit einem Träger der Kondensatoranordnung und mit dem Bodenteil bzw. den Bodenteilen der Elemente verbunden ist. Vorzugsweise kann die Verbindungsstruktur als stabförmiges Stützelement zentral innerhalb der topfförmigen Elektrodenstruktur ausgebildet sein.

Bei dem Verfahren zur Herstellung eines Kondensators wird auf einer Oberfläche einer Trägeranordnung zunächst eine Basisschicht erzeugt, die eine p⁺-Schicht enthält, auf der anschließend eine Schichtenfolge aus abwechselnd einer niedrigdotierten und einer hochdotierten p-leitenden Schicht aufgebracht wird. Danach wird die Schichtenfolge anisotrop so geätzt, daß eine Öffnung gebildet wird, die mindestens bis zur p⁺-Schicht der Basisschicht geht. Mindestens in einem Randbereich der Öffnung wird danach durch Implantation eine p⁺-leitende Zone erzeugt, die die Schichtenfolge verbindet. Anschließend werden die niedrig dotierten p-leitenden Schichten der Schichtenfolge selektiv zu den p⁺-Schichten geätzt, das Dielektrikum abgeschieden und eine Gegenelektrode gebildet.

Die Basisschicht kann dabei so erzeugt werden, daß sie nur eine p⁺-Schicht oder eine p⁺-Schicht mit einer darunterliegenden Oxid- und/oder Nitridschicht enthält. Die p⁺-Zone wird in der Öffnung durch Schrägimplantation von Ionen, d.h. Borionen, erzeugt. Wichtig dabei ist, daß die Schichtenfolge nicht vollständig von einer p⁺-Zone abgedeckt wird, um für die nachfolgende selektive Ätzung einen Angriff der Ätze auf das niedrigdotierte p-Material zu ermöglichen,

Die selektive Ätzung erfolgt mit Hilfe einer alkalischen Ätze, beispielsweise einer Ethylendiamin-Pyrokatechol- oder einer Kaliumhydroxid-Lösung. Nach dem Herausätzen der niedrigdotierten p-leitenden Schichtmaterialien wird ein Dielektrikum, beispielsweise ein ONO-Dielektrikum aufgebracht und anschließend ein leitendes Material als Gegenelektrode konform abgeschieden.

Die Basisschicht kann auf einer planarisierten Oberfläche eines Isolators erzeugt werden. Sofern in dem Isolator ein Kontaktloch zu einer darunterliegenden Anschlußfläche vorgesehen ist, kann dieses Kontaktloch ebenfalls mit dem p⁺-Material der Basisschicht aufgefüllt werden. Neben dieser vertikalen Kontaktierung der Elektrodenstruktur ist eine Kontaktierung über laterale Anschlüsse möglich. Die Basisschicht und nachfolgend die Elektrodenstruktur kann andererseits in einem Graben einer Isolationsschicht oder einer Siliziumschicht erzeugt werden. Gegebenenfalls ist unterhalb der p⁺-Teilschicht der Basisschicht eine Siliziumoxid- und/oder eine Siliziumnitridschicht vorgesehen.

Die Herstellung des Kondensators beruht auf der Erkenntnis, daß die Ätzrate von p⁺-dotiertem Silizium gegenüber niedrigdotiertem Silizium in alkalischen Ätzlösungen extrem niedrig ist. Aus der Veröffentlichung H. Seidel et. al.: Anisotropic Etching of Crystalline Silicon in Alkaline Solutions, J. Electrochem. Soc. Vol. 137, No. 11, Nov. 1990, p. 3626 bis 3632 ist die Ätzrate von p-dotiertem Silizium in einer Athylendiamin-Pyrochkatechol-Lösung bis zu einer Konzentration von 10¹⁹ cm⁻³ konstant und sinkt dann stark ab. Bei einer Konzentration von 2 · 10²⁰ cm⁻³ beträgt die Ätzrate nur noch weniger als ein Tausendstel der Ätzrate bei 10¹⁹ cm⁻³.

Die Erfindung wird nachfolgend anhand von Figuren und von Ausführungsbeispielen naher erläutert. Es zeigen:
- FIG 1a bis FIG 1f: die Herstellung eines ersten Ausführungsbeispiels eines Kondensators,
- FIG 2: einen schematischen Querschnitt durch ein zweites Ausführungsbeispiel eines Kondensators,
- FIG 3: eine schematische Draufsicht auf mögliche Geometrieanordnungen und
- FIG 4a bis c: eine schematische Herstellung durch ein drittes Ausführungsbeispiel eines Kondensators.

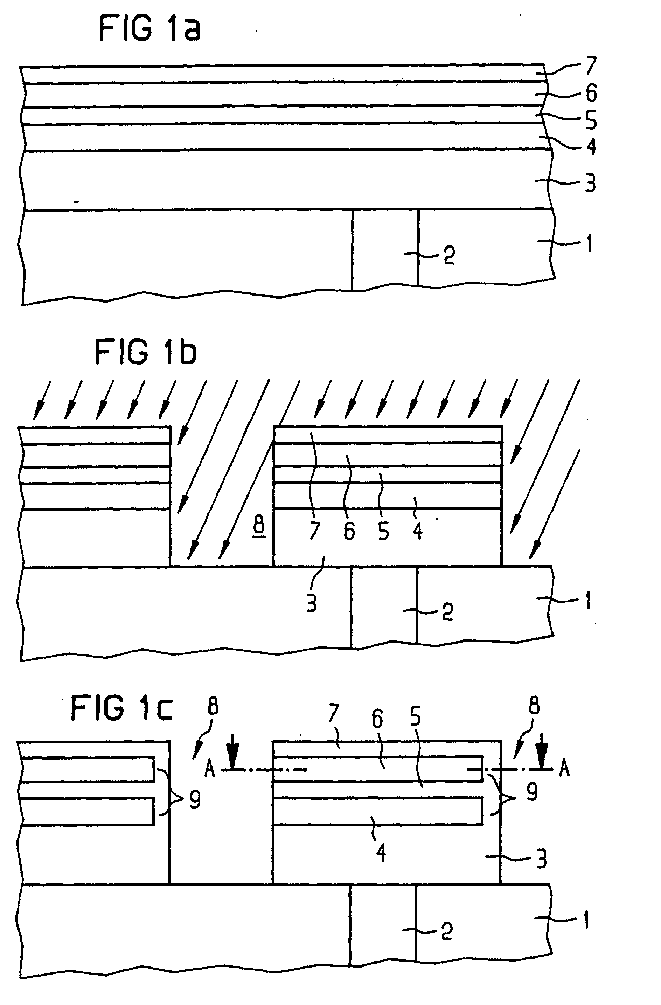

Gemäß FIG 1a ist eine Trägeranordnung vorgesehen, die an ihrer Oberfläche eine isolierende Schicht 1 aufweist. Unterhalb der isolierenden Schicht können weitere Elemente einer Halbleiteranordnung, beispielsweise Transistoren angeordnet sein. Innerhalb der isolierenden Schicht 2 ist bündig mit der Oberfläche ein Kontaktloch 2 vorgesehen, das mit einem metallisierenden Material aufgefüllt ist. Als Auffüllmaterial kann Wolfram, Tantal, Titan, Titannitrid oder dotiertes Polysilizium vorgesehen sein. Bei n-dotiertem Polysilizium ist es notwendig, dieses zu silizieren, so daß an der Oberfläche eine metallische Zwischenschicht auftritt. Das mit einem Material mit metallischer Leitfähigkeit aufgefüllte Kontaktloch 2 bildet den Anschlußkontakt für die zu erzeugende Elektrodenstruktur. Als isolierende Schicht 1 der Trägeranordnung kann eine Glasschicht, beispielsweise BPSG, vorgesehen sein, die den Vorteil einer planen Oberfläche durch Verfließen des Glases bietet. Es ist aber auch möglich, eine isolierende Schicht vorzusehen, die durch einen Polierschritt, beispielsweise CMP, planarisiert ist.

Auf der Oberfläche der Trägeranordnung und des Kontaktlochs 2 wird anschließend eine Basisschicht 3 erzeugt, die im Ausführungsbeispiel eine hochdotierte p-leitende Schicht ist. Die Höhe der Dotierung richtet sich nach der Wahl der später einzusetzenden Ätzlösung und sollte so gewählt sein, daß die Ätzrate außerordentlich gering ist. Beispielsweise ist es zweckmäßig, für eine Ethylendiamin-Pyrokatechol-Lösung eine Borkonzentration > 10²⁰ cm⁻³ zu wählen. Die Dicke der Basisschicht kann beispielsweise 300 nm betragen. Auf der hochdotierten p-leitenden Schicht der Basisschicht 3 wird anschließend eine Schichtenfolge aus abwechselnd einer p⁻-Schicht und einer p⁺-Schicht aufgebracht. Die hochdotierten Schichten 5 und 7 werden dabei entsprechend wie die hochdotierte p-leitende Schicht der Basisschicht dotiert. Die niedrig dotierten p-leitenden Schichten 4 und 6 weisen eine Dotierung auf, die hinsichtlich der selektiv wirkenden Ätze eine hohe Ätzrate ermöglichen. Beispielsweise beträgt die Bordotierung bei der zuvor beschriebenen Ethylendiamin-Pyrokatechol-Lösung etwa 10¹⁹ cm⁻³ oder weniger.

Die Schichtendicken werden so gewählt, daß die niedrig dotierten p-leitenden Schichten dicker sind als die hochdotierten p-leitenden Schichten. Beispielsweise sind die p⁻-Schichten 30 nm und p⁺-Schichten 5 und 7 10 nm dick.

Die Schichten 3 bis 7 werden konform abgeschieden. Mögliche Abscheideverfahren sind die chemische Abscheidung aus der Dampfphase bei niedrigen Drücken, insbesondere die Heißwand- oder Kaltwand-LPCVD, oder die Molekularstrahlepitaxie. Die Schichtenfolge kann in situ in ein und demselben Reaktor aufgebracht werden. Dazu ist es notwendig, für die p⁻-dotierten Schichten 4 und 6 im Vergleich zu den p⁺-dotierten Polysiliziumschichten 3, 5 und 7 andere Prozeßparameter einzustellen.

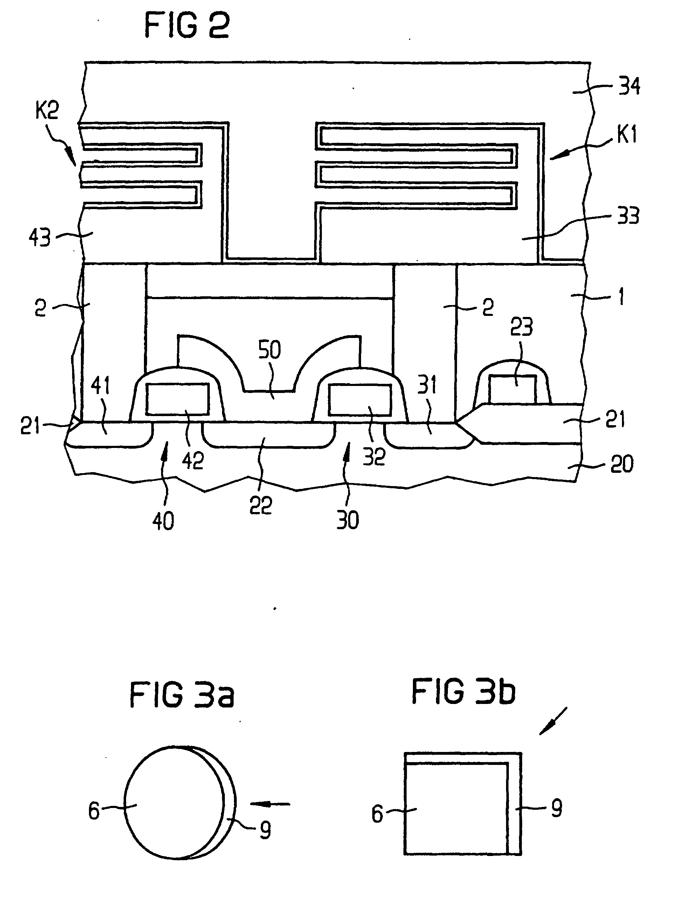

Anschließend wird gemäß FIG 1b eine nichtdargestellte Maske erzeugt, mit deren Hilfe die Schichtenfolge 3 bis 7 anisotrop geätzt wird, so daß eine oder mehrere Öffnungen 8 gebildet werden. Als Ätzmittel kommt KOH in Frage. In der FIG sind die Öffnungen 8 bis auf die isolierende Schicht der Trägeranordnung 1 durchgeätzt. Dadurch entstehen separierte Inseln, in denen jeweils ein Kondensator hergestellt werden kann. Wenn die Basisschicht 3 nicht vollständig durchgeätzt wird, entsteht eine großflächige Kondensatoranordnung. Die Strukturierung der Polysiliziumschichtenfolge erfolgt so, daß die Stapel in der Draufsicht rund oder eckig sind, FIG 3.

Im nächsten Schritt wird in einem Randbereich der Öffnung 8 eine hochdotierte p-leitende Zone erzeugt, die die Schichtenfolge 3 bis 7 verbindet. Dazu erfolgt eine Schrägimplantation von BF₂-Ionen, beispielsweise unter einem Winkel von 8° zur Senkrechten. Alternativ ist es dabei möglich, auch die andere Seite der in FIG 1b gezeigten Öffnung mit Bor-Ionen zu Implantieren. Die Implantation hat die Wirkung, daß in dem Randbereich der Öffnung, der unter dem Beschuß der Bor-Ionen liegt, eine begrenzte Zone der niedrigdotierten p-leitenden Schichten 4 und 6 hochdotiert werden, wobei die Dotierung der Dotierung der übrigen p⁺-Polysiliziumschichten entspricht. Anschließend ist ein Temperaturschritt vorgesehen, um sicherzustellen, daß die implantierten Bor-Ionen aktiviert werden, d.h. die entsprechenden Gitterplätze in der Polysiliziumschicht 4 bzw. 6 belegen. Hierbei ist es erforderlich, daß keine Diffusion aus den hochdotierten Zonen in die niedrigdotierten Zonen erfolgt. Der Temperaturschritt kann vorzugsweise mit Hilfe eines RTA-(Rapid Thermal Annealing)Verfahrens erfolgen. Die gewählte Temperatur beträgt etwa 850 bis 900° C.

FIG 1c zeigt die nach dem Temperaturschritt entstandene Struktur. Durch die Schrägimplantation der Bor-Ionen in die Öffnungen 8 ist im Randbereich jeder Öffnung eine p⁺-Zone 9 erzeugt worden, die die p⁺-Schichten 3, 5 und 7 miteinander verbindet. Im Ausführungsbeispiel haben die p⁺-Zonen die Form eines nach links gestellten "E". Auf dem den Zonen 9 gegenüberliegenden Randbereich der Öffnungen 8 ist dagegen die ursprünglich erzeugte Schichtenfolgen 3 bis 7 erhalten, so daß die niedrigdotierten Schichten 4 und 6 frei zur Öffnung zeigen.

Wenn mit dem anisotropen Ätzschritt, mit dem die Öffnungen 8 erzeugt sind, eine strukturierte Schichtenfolge erzeugt ist, die in der Draufsicht rund ist, dann erstrecken sich die Zonen 9 mit abnehmender Dicke über einen bestimmten Teil des Umfangs des Stapels. Mit einem rechteckigen Stapel laßt sich erreichen, daß nur eine Seite des Stapels oder aber zwei Seiten des Stapels randseitig p⁺-dotiert sind, wodurch die Zonen 9 entweder nur an einer.Seite des Stapels vorhanden sind oder aber winkelförmig zwei Seiten des Stapels abdecken. Der Durchmesser eines derartig geformten Stapels bzw. die Breite beträgt etwa 1 µm. FIG 3 zeigt Beispiele für die Ausführung der strukturierten und dotierten Stapel gemäß FIG 1c. Angedeutet ist jeweils die Richtung, mit der die Implantierung erfolgte. In den in FIG 3 gezeigten Beispielen ergibt sich für den zu erzeugenden Kondensator eine sehr stabile Struktur.

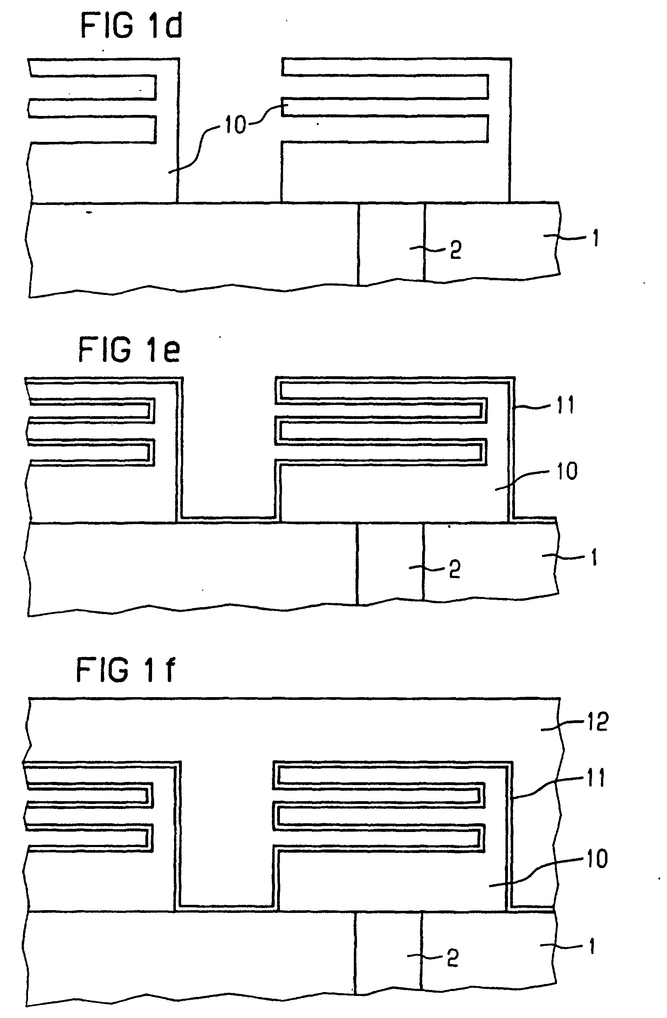

Im nächsten Schritt wird die Anordnung selektiv isotrop mit einer alkalischen Ätze geätzt. Als Ätzlösung kommt beispielsweise Ethylendiamin-Pyrokatechol in Frage. Bei der gewählten Dotierung weisen die alkalischen Ätzlösungen die Eigenschaft auf, daß die niedrigdotierten p-leitenden Schichten mit einer Selektivität von 100:1 bis 1000:1 stärker geätzt werden als die p⁺-dotierten Schichten. Nach dem Ätzvorgang ergibt sich eine Struktur gemäß FIG 1d, bei der nur noch die p⁺-dotierten Bereiche geblieben sind, die untereinander derart verbunden sind, daß sich eine Stützstruktur ergibt. Die Struktur ist mit 10 bezeichnet.

Mit dem nächsten Schritt wird gemäß FIG 1e das Kondensator-dielektrikum konform abgeschieden. Das Dielektrikum kann aus Siliziumoxid und/oder Siliziumnitrid gebildet sein. Vorzugsweise ist eine ONO-Dielektrikumsschicht vorgesehen, die aus einer ersten Siliziumoxidschicht, einer Siliziumnitridschicht und einer zweiten Siliziumoxidschicht besteht. Insgesamt ist eine Schichtdicke des Kondensatordielektrikums von etwa 10 nm vorgesehen. Für höhere zu erzeugende Kapazitäten kann die Dicke des Kondensatordielektrikums jedoch auch kleiner gewählt werden, beispielsweise 3 nm.

Auf dem Kondensatordielektrikum 11 wird mittels konformer Abscheidung die Gegenelektrode des Kondensators 12 erzeugt, beispielsweise als p⁺-dotiertes Polysilizium. Als Abscheideverfahren kommen die gleichen Verfahren in Betracht, die bereits für die Erzeugung der Schichtenfolge eingesetzt worden sind.

Die Gegenelektrode 12 kann mit üblichen Methoden der Halbleitertechnik gegebenenfalls strukturiert und kontaktiert werden.

FIG 2 zeigt ein zweites Ausführungsbeispiel des Kondensators, wobei der Kondensator als Speicherkondensator in einer DRAM-Halbleiteranordnung vorgesehen ist. Dabei enthält die Trägeranordnung unterhalb der isolierenden Schicht 1 die Auswahltransistoren für die Speicherkapazität. In einem Substrat 20 sind mit Hilfe von Feldoxidgebieten 21 isolierte Bereiche gebildet. Ein isolierter Bereich enthält zwei Auswahltransistoren 30 bzw. 40, die eine gemeinsame Source-Zone 22 haben. Beidseitig von der Source-Zone 22 erstreckt sich das Kanalgebiet, das von einem im Querschnitt allseitig isolierten Gate 32 bzw. 42 als Wortleitung gesteuert wird. Zum Feldoxid 21 hin haben die Transistoren jeweilige Drain-Gebiete 31 bzw. 41. Jedes Drain einer Speicherzelle, die aus einem Auswahltransistor und einem Kondensator gebildet ist, ist über ein Kontaktloch in der isolierenden Schicht mit der Elektrodenstruktur eines Kondensators verbunden. Beispielsweise ist der Drain 31 des Transistors 30 mit der Elektrode 33 eines ersten Kondensators K1 und der Drain 41 des Transistors 40 mit der Elektrode 43 des Kondensators K2 verbunden. Die Elektrodenstruktur 33 bzw. 43 ist im Gegensatz zu dem Ausführungsbeispiel der FIG 1 dadurch erzeugt, daß in der Trägerschicht 1 die Kontaktlöcher 2 zunächst als selbstjustierte überlappende Kontakte zu den Drainzonen des jeweiligen Transistors hergestellt werden und daß danach die p⁺-dotierte Basisschicht mittels konformer Abscheidung erzeugt ist, mit der das Kontaktloch aufgefüllt wird. Im Ausführungsbeispiel der FIG 2 sind die Source- und Drain-Zonen 22, 31 und 41 als p⁺-dotierte Gebiete, entsprechend p-Kanal-Auswahltransistoren vorgesehen. Bei n-Kanal-Auswahltransistoren muß das Kontaktloch 2 eine Zwischenschicht mit einem metallisch leitfähigen Material aufweisen, beispielsweise Wolfram, Tantal, Titan, Titannitrid oder einem Silizid. Oberhalb des Feldoxidbereichs 21 sind die Wortleitungen 23 für die nächsten Speicherzellen angeordnet. Die Wortleitungen 23, 32 und 42 bestehen vorzugsweise aus hochdotiertem Polysilizium oder Polyzid. Die Sourcezone 22 ist mit Hilfe eines selbstjustierten überlappenden Kontakts mit der Bitleitung 50 kontaktiert, die aus Wolfram oder Polyzid besteht. In der genannten Speicheranordnung der FIG 2 haben alle Kondensatoren eine gemeinsame Gegenelektrode 34, die sogenannte Zellplatte.

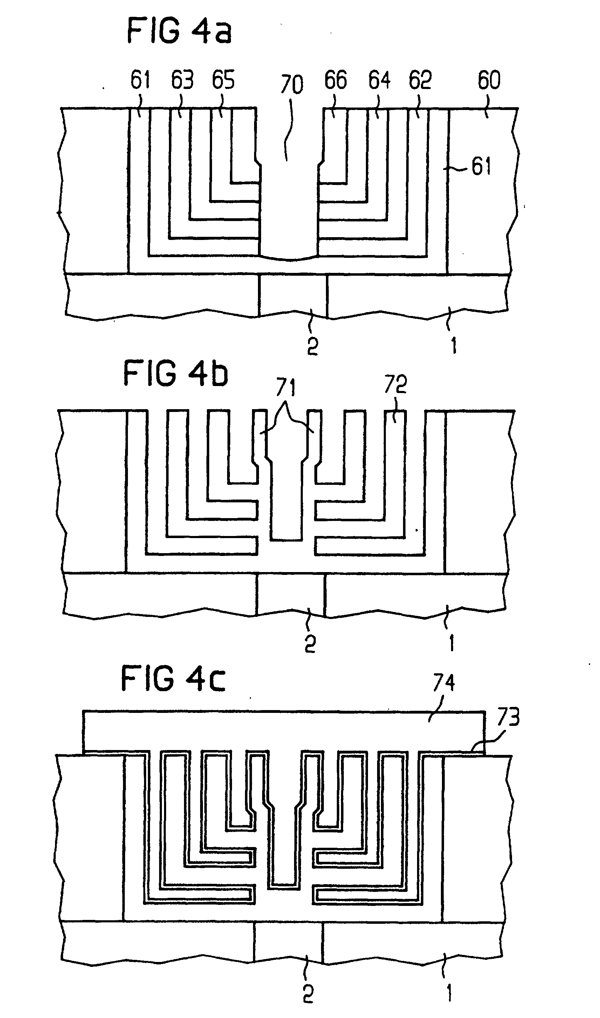

FIG 4 zeigt ein weiteres Ausführungsbeispiel des Kondensators, der in diesem Fall als topfförmige Anordnung ausgebildet ist. Auf einem Träger 1 mit einem beispielsweise mit Metall aufgefüllten Kontaktloch 2 ist zunächst eine Isolatorschicht 60 gebildet, die anschließend strukturiert wird, so daß eine Öffnung bis auf die Trägerschicht 1 bzw. das aufgefüllte Kontaktloch 2 entsteht. Mittels konformer Abscheidung werden in der geschilderten Weise zunächst eine Basisschicht 61 aus hochdotiertem p-leitendem Polysilizium und daran anschließend eine Schichtenfolge aus abwechselnd einer niedrigdotierten und einer hochdotierten p-leitenden Schicht aufgebracht. Die niedrigdotierten Schichten sind als 62, 64 und 66 bezeichnet, die hochdotierten Schichten als 63 und 65. Es ergibt sich zunächst eine Struktur, bei der die Schichten 61 bis 66 topfförmig ineinanderliegen, wobei die später aufgebrachten Schichten kleinere Boden- und Randabmessungen haben als die zuerst aufgebrachten Schichten. Mittels einer Maskentechnik und einem anschließenden anisotropen Ätzschritt wird mittig in der Schichtenfolge eine Öffnung 70 erzeugt, die bis auf die Basisschicht 61 reicht. Dadurch wird im Bodenbereich die Schichtenfolge freigelegt, FIG 4a.

Bei einer ausreichend großen Öffnung im Vergleich zur Randhöhe der Schichten wird erfindungsgemäß durch Schrägimplantation eine hochdotierte leitende zone erzugt. Mittels einer Maske und einem oder mehreren nachfolgenden Implantationsschritten wird der durch die Maskenöffnung definierte Bereich am Boden der Schichtenfolge mit p⁺-Atomen dotiert. Vorzugsweise werden mehrere Implantationsschritte so vorgesehen, daß das Dotierungsmaximum jeweils in einem p⁻-Schichtbereich liegt. Es entsteht eine im Bodenbereich durch die Öffnung der Maske definierte p⁺-Stütze.

Die p⁺-dotierten Zonen haben eine Dotierungskonzentration von mindestens 10²⁰ cm⁻³, während die niedrigdotierten p⁻-Zonen 62, 64 und 66 eine Dotierungskonzentration von höchstens 10¹⁹ cm⁻³ haben. Es kann sich ein Temperaturschritt anschließen, beispielsweise ein RTA-Schritt, so daß keine Diffusion aus den p⁺-dotierten Schichten erfolgen kann. Anschließend wird die Struktur selektiv isotrop in einer alkalischen Ätzlösung geätzt. Dabei bleiben die p⁺-dotierten Schichten stehen, während die p⁻-dotierten Schichten herausgeätzt werden. Die Selektivität des Ätzverfahrens ist dabei ausreichend hoch, so daß eine Stützstruktur wie in FIG 4b entsteht, die Ähnlichkeit mit einem Leuchter hat. Die Zone 71 verbindet die in FIG 1 erkennbare Schichtenfolge 61 bis 66 im Bodenbereich der Schichtenfolge.

Gemäß FIG 4c wird anschließend ein Dielektrikum 73, beispielsweise als ONO-Dielektrikum und eine Gegenelektrode 74, beispielsweise aus p⁺-dotiertem Polysilizium mittels konformer Abscheidung erzeugt. Dielektrikum und Gegenelektrode 74 können anschließend strukturiert werden.

Es ist möglich, wie in FIG 2 die Basisschicht mittels konformer Abscheidung auch in dem Kontaktloch 2 abzuscheiden, wenn dies gewünscht wird. Weiterhin ist es möglich, einen Kondensator der in FIG 4 gezeigten Art in einem Siliziumsubstrat anzuordnen und die Elektrodenstruktur am Grabenrand mit einer Halbleiteranordnung, beispielsweise einem Auswahltransistor einer DRAM-Anordnung zu verbinden. In diesem Fall kann die Gegenelektrode 74 wie bei bekannten Grabenkondensatoren als durchgehende Zellplatte ausgebildet sein. Wenn der Kondensator in einem Siliziumsubstrat als Grabenkondensator angeordnet ist, reicht es, bei einem p-Substrat die Basiszone durch eine Höherdotierung des Grabenbereichs zu erzeugen. In einem n-dotierten Substrat ist vorgesehen, die hochdotierte p-leitende Schicht der Basisschicht 61 durch eine isolierende Schicht vom Substrat zu isolieren. Eine derartige Schicht kann aus Siliziumoxid und/oder Siliziumnitrid gebildet sein.

## Patentansprüche

1. Verfahren zur Herstellung einer Halbleiteranordnung mit einem Kondensator mit folgenden Schritten:
- auf einer Oberfläche einer Trägeranordnung wird eine Basisschicht erzeugt, die eine hochdotierte p-leitende Schicht (3, 61) enthält,
- auf die Oberfläche der hochdotierten p-leitenden Schicht (3, 61) wird eine Schichtenfolge (4-7; 62-66) aus abwechselnd einer niedrigdotierten und einer hochdotierten p-leitenden Schicht aufgebracht,
- die Schichtenfolge wird mittels einer anisotropen Ätzung unter Bildung mindestens einer bis zur Basisschicht reichenden Öffnung (8; 70) strukturiert,
- in einem Randbereich der Öffnung wird eine hochdotierte p-leitende Zone (9) durch Schrägimplantation von Ionen in die Schichtenfolge aus niedrigdotierten und hochdotierten p-leitenden Schichten erzeugt, so daß die hochdotierte p-leitende Zone (9) die Schichtenfolge bis zur hochdotierten p-leitenden Schicht (3, 61) der Basisschicht verbindet,
- die niedrigdotierten p-leitenden Schichten der Schichtenfolge werden selektiv zu den hochdotierten p-leitenden Schichten der Schichtenfolge und zu der hochdotierten p-leitenden Zone (9) geätzt,
- ein Kondensatordielektrikum (11) wird konform abgeschieden und
- auf das Kondensatordielektrikum wird eine leitende Schicht (12) konform abgeschieden.

2. Verfahren nach Anspruch 1,
**dadurch gekennzeichnet,**
**daß** die Basisschicht mittels einer hochdotierten p-leitenden Schicht (3, 61) erzeugt wird, die durch flächige Dotierung einer Halbleiterzone oder durch Abscheiden eines dotierten Halbleitermaterials erzeugt wird.

3. Verfahren nach Anspruch 2,
**dadurch gekennzeichnet,**
**daß** die Basisschicht eine Oxidschicht und/oder eine Nitridschicht aufweist, die vor der hochdotierten p-leitenden Schicht (3, 61) aufgebracht wird.

4. Verfahren nach einem der Ansprüche 1 bis 3,
**dadurch gekennzeichnet,**
**daß** die Basisschicht auf einer planarisierten Oberfläche einer Trägerschicht aufgebracht wird.

5. Verfahren nach einem der Ansprüche 1 bis 4,
**dadurch gekennzeichnet,**
**daß** die Schrägimplantation mittels Borfluorid-Ionen oder Bor-Ionen erfolgt.

6. Verfahren nach einem der Ansprüche 1 bis 5,
**dadurch gekennzeichnet,**
**daß** nach Erzeugung der hochdotierten p-leitenden Zone (9) ein Temperaturschritt erfolgt.

7. Verfahren nach einem der Ansprüche 1 bis 6,
**dadurch gekennzeichnet,**
**daß** die selektive Ätzung isotrop mittels einer alkalischen Ätze erfolgt.

8. Verfahren nach einem der Ansprüche 1 bis 7,
**dadurch gekennzeichnet,**
**daß** als Ätze eine Ethylendiamin-Pyrokatechol-Lösung oder eine Kaliumhydroxid-Lösung verwendet wird.

9. Verfahren nach einem der Ansprüche 1 bis 8,
**dadurch gekennzeichnet,**
**daß** als Kondensatordielektrium (11) Siliziumoxid und/oder Siliziumnitrid konform abgeschieden wird.

10. Verfahren nach einem der Ansprüche 1 bis 9,
**dadurch gekennzeichnet,**
**daß** die Schichtenfolge übereinander oder nebeneinander aufgebracht wird.

11. Verfahren nach einem der Ansprüche 1 bis 10,
**dadurch gekennzeichnet,**
**daß** die Schichtenfolge topfförmig ineinander verschachtelt wird.

12. Verfahren nach einem der Ansprüche 1 bis 11,
**dadurch gekennzeichnet,**
**daß** auf dem Kondensatordielektrikum (11) eine Gegenelektrode (12) aus hochdotiertem p-leitendem Material erzeugt wird.

## Claims

1. Method for producing a semiconductor arrangement with a capacitor, having the following steps:
- a base layer, which contains a heavily doped, p-conducting layer (3, 61), is produced on a surface of a carrier arrangement,
- a layer sequence (4-7; 62-66) consisting alternately of a weakly doped and a heavily doped p-conducting layer is applied to a surface of the heavily doped, p-conducting layer (3, 61),
- the layer sequence is patterned by means of anisotropic etching, forming in the process at least one opening (8; 70) which reaches down to the base layer,
- a heavily doped p-conducting zone (9) is produced in one edge region of the opening by inclined implantation of ions into the layer sequence consisting of weakly doped and heavily doped p-conducting layers, so that the heavily doped p-conducting zone (9) connects the layer sequence as far as the heavily doped-conducting layer (3, 61) of the base layer,
- the weakly doped, p-conducting layers of the layer sequence are etched selectively with respect to the heavily doped p-conducting layers of the layer sequence and with respect to the heavily doped p-conducting zone (9),
- a capacitor dielectric (11) is conformally deposited, and
- a conductive layer (12) is conformally deposited on the capacitor dielectric.

2. Method according to Claim 1, **characterized in that** the base layer is produced by means of a heavily doped, p-conducting layer (3, 61) which is produced by areal doping of a semiconductor zone or by deposition of a doped semiconductor material.

3. Method according to Claim 2, **characterized in that** the base layer has an oxide layer and/or a nitride layer which is applied before the heavily doped, p-conducting layer (3, 61).

4. Method according to one of Claims 1 to 3, **characterized in that** the base layer is applied to a planarized surface of a carrier layer.

5. Method according to one of Claims 1 to 4, **characterized in that** the inclined implantation is effected by means of boron fluoride ions or boron ions.

6. Method according to one of Claims 1 to 5, **characterized in that** a temperature step takes place after the production of the heavily doped, p-conducting zone (9).

7. Method according to one of Claims 1 to 6, **characterized in that** the selective etching takes place isotropically by means of an alkaline etchant.

8. Method according to one of Claims 1 to 7, **characterized in that** an ethylenediamine/pyrocatechol solution or a potassium hydroxide solution is used as the etchant.

9. Method according to one of Claims 1 to 8, **characterized in that** silicon oxide and/or silicon nitride is conformally deposited as the capacitor dielectric (11).

10. Method according to one of Claims 1 to 9, **characterized in that** the layer sequence is applied one above the other or next to one another.

11. Method according to one of Claims 1 to 10, **characterized in that** the layer sequence is nested one in the other in a pot-shaped manner.

12. Method according to one of Claims 1 to 11, **characterized in that** a counter-electrode (12) made of heavily doped, p-conducting material is produced on the capacitor dielectric (11).

## Revendications

1. Procédé de fabrication d'un dispositif à semi-conducteur ayant un condensateur comportant les stades suivants :
- on produit sur une surface d'un dispositif support une couche de base qui a une couche (3, 61) très dopée de conductivité p,
- on dépose sur la surface de la couche (3, 61) très dopée de conductivité p une succession (4-7 ; 62-66) de couches constituée en alternance d'une couche peu dopée et d'une couche très dopée de conductivité p,
- on structure la succession de couches au moyen d'une attaque chimique anisotrope avec formation d'au moins une ouverture (8 ; 70) allant jusqu'à la couche de base,
- dans une zone du bord de l'ouverture, on produit une zone (9) très dopée de conductivité p, par implantation inclinée d'ions, dans la succession de couches constituée de couches peu dopées et très dopées de conductivité p, de sorte que la zone (9) très dopée de conductivité p relie la succession de couches jusqu'à la couche (3, 61) très dopée de conductivité p de la couche de base,
- on attaque chimiquement les couches peu dopées de conductivité p de la succession de couches sélectivement par rapport aux couches très dopées de conductivité p de la succession de couches et par rapport à la zone (9) très dopée de conductivité p,
- on dépose de manière conforme un diélectrique (11) de condensateur, et
- on dépose de manière conforme une couche (12) conductrice sur le diélectrique de condensateur.

2. Procédé suivant la revendication 1, **caractérisé en ce que** l'on produit la couche de base au moyen d'une couche (3, 61) très dopée de conductivité p, qui est produite par dopage plat d'une zone semi-conductrice ou par dépôt d'un matériau semi-conducteur dopé.

3. Procédé suivant la revendication 2, **caractérisé en ce que** la couche de base comporte une couche d'oxyde et/ou une couche de nitrure qui est déposée avant la couche (3, 61) très dopée de conductivité p.

4. Procédé suivant l'une des revendications 1 à 3, **caractérisé en ce que** la couche de base est déposée sur une surface planarisée d'une couche support.

5. Procédé suivant l'une des revendications 1 à 4, **caractérisé en ce que** l'implantation inclinée s'effectue au moyen d'ions de fluorure de bore ou d'ions bore.

6. Procédé suivant l'une des revendications 1 à 5, **caractérisé en ce que** l'on effectue après la production de la zone (9) très dopée de conductivité p un stade thermique.

7. Procédé suivant l'une des revendications 1 à 6, **caractérisé en ce que** l'on effectue l'attaque chimique sélective de manière isotrope au moyen d'un agent d'attaque chimique alcalin.

8. Procédé suivant l'une des revendication 1 à 7, **caractérisé en ce que** l'on utilise comme agent d'attaque chimique une solution d'éthylènediamine et de pyrocatéchine ou une solution d'hydroxyde de potassium.

9. Procédé suivant l'une des revendications 1 à 8, **caractérisé en ce que** l'on dépose de manière conforme de l'oxyde de silicium et/ou du nitrure de silicium comme diélectrique (11) du condensateur.

10. Procédé suivant l'une des revendications 1 à 9, **caractérisé en ce que** l'on dépose les couches de la succession les unes au-dessus des autres ou les unes à côté des autres.

11. Procédé suivant l'une des revendications 1 à 10, **caractérisé en ce que** les couches de la succession sont emboîtées les unes dans les autres en forme de cuvette.

12. Procédé suivant l'une des revendications 1 à 11, **caractérisé en ce que** l'on produit sur le diélectrique (11) du condensateur une contre-électrode (12) en matériau très dopé de conductivité p.
